# EUROPÄISCHE PATENTSCHRIFT

(11) **EP 0 528 163 B1**
(45) Veröffentlichungstag und Bekanntmachung des Hinweises auf die Patenterteilung: **13.09.1995**
(21) Anmeldenummer: 92111749.5
(22) Anmeldetag: 10.07.1992
(51) Int. Cl.: H01J 37/32, H02H 7/00, H02H 3/44

(54) **Einrichtung zur Unterdrückung von Lichtbögen**
Device for suppressing arcing
Dispositif pour supprimer des décharge d'arc

(30) Priorität: 20.08.1991 DE 4127504
(43) Veröffentlichungstag der Anmeldung: 24.02.1993
(73) Patentinhaber: LEYBOLD AKTIENGESELLSCHAFT, D-63450 Hanau (DE)
(72) Erfinder: Teschner, Götz, Dipl.-Ing., W-6460 Gelnhausen (DE)
(74) Vertreter: Schickedanz, Willi, Dipl.-Ing.

(56) Entgegenhaltungen:
- EP-A- 0 095 590
- EP-A- 0 186 865
- WO-A-91/15027
- FR-A- 2 648 001

## Beschreibung

Die Erfindung betrifft eine Lichtbogenunterdrückungsschaltung nach dem Oberbegriff des Patentanspruchs 1.

In der Gasentladungstechnik ist es oft erforderlich, ein Gas in einen Plasmazustand zu bringen, ohne daß es zu Bogenentladungen kommt. Beispielsweise dürfen bei der Glasbeschichtung, wo SiO₂ durch Sputtern auf ein Trägermaterial, ein sogenanntes Substrat, aufgebracht wird, keine Überschläge stattfinden, weil sonst sowohl das Target als auch das Substrat zerstört werden. Wegen der zahlreichen physikalischen Ursachen, die zu einer Bogenentladung führen können, ist es extrem schwierig, die Bogenentladung als solche zu verhindern. Es ist jedoch möglich, die Ausbildung einer Bogenentladung mit hoher Stromstärke zu unterdrücken.

Wie nähere Untersuchungen der Bogenentladungen ergeben haben, führen nicht alle Entladungen zum sofortigen Zusammenbrechen des Isolationsvermögens. Es treten vielmehr auch Spannungsverläufe auf, bei denen erst einige Millisekunden nach einem ersten Rückgang der Spannung auf 150 bis 300 V der Zusammenbruch auf die Lichtbogenbrennspannung erfolgt. Diese in Stufen sich herausbildenden Spannungszusammenbrüche werden von einfachen Schwingkreisen nicht erkannt, die üblicherweise zum Löschen eingesetzt werden. Wegen ihrer langen Brenndauer und ihres damit verbundenen hohen Energieinhalts führen die mehrstufigen Lichtbögen schnell zur Zerstörung der Targetoberfläche.

Bei einem bekannten Kathoden-Lichtbogenbeschichtungsverfahren, bei dem ein Lichtbogen auf ein Target trifft und dort geladene Teilchen herausschlägt, die auf ein Substrat gelangen, sinkt die Impedanz zwischen den Elektroden, zwischen denen der Lichtbogen auftritt, sehr stark ab. Um diese Impedanz am Ende eines Bearbeitungsvorgangs wieder zu erhöhen, ist es bekannt, die aus dem Target herausgeschlagenen Teilchen verstärkt in Richtung Substrat durch ein entsprechendes elektrisches Potential abzusaugen (US-PS 4 936 960). Nachteilig ist indessen bei diesem Verfahren, daß es nur bei der Lichtbogenbeschichtung anwendbar ist.

Weiterhin ist es bekannt, beim Auftreten einer Bogenentladung einer Anlage die geringstmögliche Energie zuzuführen bzw. die Energiezufuhr ganz zu unterbinden. Dabei soll die Energiezufuhr solange unterbunden bleiben, bis sich die gesamte Zone um die Bogenentladung herum stabilisiert hat (D. S. Schatz, The MDX as a Strategic Tool in Reducing Arcing, Schrift der Advanced Energy Industries, Inc., 1985). Eine weitere bekannte Maßnahme, um die Wahrscheinlichkeit der Lichtbogenbildung zu verringern, besteht darin, die Welligkeit der Energiezufuhr zu vermindern, und zwar über den gesamten Impedanzbereich. Auch die Verwendung schneller Regeleinrichtungen wurde vorgeschlagen, um die Abweichungen der Versorgungsspannung vom Soll-Wert schnell anzugleichen (D. S. Schatz, a. a. O.). Zur Löschung von Lichtbögen wird eine Umschwingschaltung vorgeschlagen, wie sie in der Thyristortechnik üblich ist.

Außerdem ist ein dynamisches Verfahren zur Überwachung einer meßgröße bekannt, bei dem die Meßanordnung die zeitliche Anderung einer Meßgröße erfaßt, wobei dieses Signal direkt und verrögert einem Differenzverstärker zugeführt wird. Beim Überschreiten einer vorgegebenen Wert resultiert die Entstehende Spannungsdifferenz in ein Steuersignal (siehe EP-A-95590).

Schließlich ist auch noch eine weitere Einrichtung bekannt, mit der die Auswirkungen von Bogenentladungen vermindert werden können (FR-A-2 648 001). Diese Einrichtung weist zwei Elektroden auf, die mit Gleichstrom versorgt werden, sowie eine Schaltung, welche die Stromzufuhr unterbricht, wenn der Strom einen vorgegebenen Wert überschreitet. Diese Schaltung wird somit bei jeder Stromstärkenüberschreitung aktiviert, so daß es zu unnötigen Unterbrechungen des Betriebs einer Plasmakammer kommt.

Der Erfindung liegt die Aufgabe zugrunde, eine verbesserte Schaltungsanordnung zum Löschen von Lichtbögen in Plasma-Vorrichtungen zu schaffen.

Diese Aufgabe wird gemäß den Merkmalen des Patentanspruchs 1 gelöst.

Der mit der Erfindung erzielte Vorteil besteht insbesondere darin, daß auch beim Sputtern von schwierigen Materialen, z. B. von SiO₂, hohe Beschichtungsraten möglich sind, weil der Sputtervorgang nur für sehr kurze Zeit unterbrochen wird. Beim SiO₂-Sputtern werden aus einem Target aus Reinst-Silizium, das sich in einer Argon-Sauerstoff-Atmosphäre von 10⁻³ bis 10⁻¹ mbar befindet, durch Ionen Si-Atome herausgeschlagen, die sich mit Sauerstoff zu SiO₂ verbinden, das sich auf einem Substrat niederschlägt.

Die Lichtbogenausbildung kann, wie Versuche gezeigt haben, im einzelnen so erfolgen, daß nach einem ersten Spannungsrückgang die Kathodenspannung für mehrere Millisekunden auf einem Spannungswert von ca. 250 V bleibt. Dieser Spannungswert liegt noch im zulässigen Arbeitsbereich der Kathode. Danach bricht die Kathodenspannung auf einem Lichtbogenwert von 30 V bis 50 V zusammen. Physikalisch wird diese Zwischenstufe mit dem Aufbau einer Ladungsträgerwolke an der Kathode gedeutet. Die Ausbildung eines vollständigen Lichtbogens führt zu einer lokalen Aufheizung der Kathodenoberfläche und damit des Targets, die auch als "hot spot" bezeichnet wird. Um einen Sputterbetrieb weiter zu ermöglichen, muß vor dem Wiedereinschalten der Kathodenspannung dieser "hot spot" abgekühlt sein, so daß er keine thermische Emission von Elektronen bewirken kann. Je frühzeitiger ein Lichtbogen erkannt und der Kathodenstrom abgeschaltet wird, um so geringer ist die Wahrscheinlichkeit, daß es zu einer nennenswerten Aufheizung kommt.

Mit der Erfindung kann ein Lichtbogen erkannt und an eine Schalteinrichtung signalisiert werden, bevor die Stromstärke im Lichtbogen so stark angewachsen ist, daß Schäden im Target- und/oder Substratbereich auftreten können, wie z. B. Materialspritzer vom Target zum Substrat oder Ausplatzungen des Targets. Da bei der Erfindung nicht feste Grenzen für Strom und Spannung überwacht werden, sondern die Veränderung der Spannung im Zeitverlauf kontrolliert wird, ist eine wesentlich frühere Lichtbogenerkennung möglich.

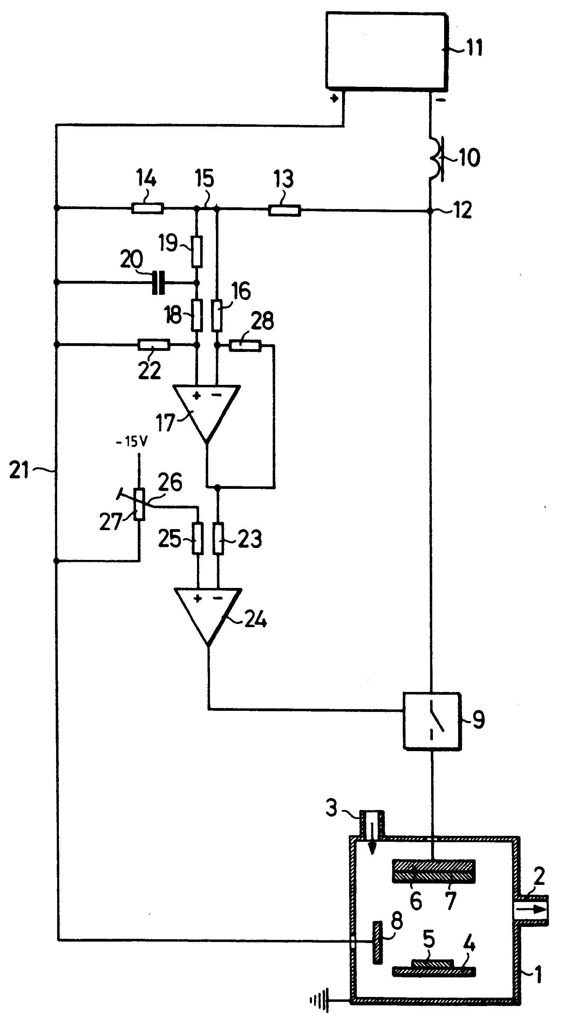

Ein Ausführungsbeispiel der Erfindung ist in der Zeichnung dargestellt und wird im folgenden näher beschrieben.

Die einzige Figur zeigt das Prinzip einer Sputteranlage mit der erfindungsgemäßen Beschaltung.

In einer Vakuumkammer 1, die einen Stutzen 2 zum Evakuieren dieser Kammer 1 und einen Stutzen 3 für die Zufuhr von Gasen aufweist, befindet sich ein Substrathalter 4, auf dem ein Substrat 5 angeordnet ist. Das Substrat 5 besteht beispielsweise aus Glas oder ist eine Kunststoffolie bzw. ein Silizium-Wafer aus der Mikroelektronikfertigung. Die Vakuumkammer 1 besteht vorzugsweise aus Metall und ist geerdet. Gegenüber dem Substrat 5 ist eine Kathode 6 mit einem Target 7 angeordnet. Die zugehörige Anode 8 befindet sich seitlich zum Substrat 5.

Von der Kathode 6 führt über einen Schalter 9 und eine Drossel 10 eine elektrische Verbindung auf den negativen Ausgang einer Gleichspannungsquelle 11. Der positive Ausgang dieser Gleichspannungsquelle 11 ist mit der Anode 8 verbunden.

An einem Verbindungspunkt 12 zwischen Drossel 10 und Schalter 9 ist ein Widerstand 13 angeschlossen, der mit einem zweiten Widerstand 14 in Verbindung steht, der seinerseits mit der Anode und dem positiven Ausgang der Spannungsquelle 11 verbunden ist. An die Verbindungsleitung 15 zwischen den beiden Widerständen 13, 14 ist ein weiterer Widerstand 16 angeschlossen, der an einem ersten Eingangsanschluß eines Differenzverstärkers 17 liegt. Der zweite Eingang dieses Differenzverstärkers ist über einen Widerstand 18 und einen Widerstand 19 ebenfalls an die Verbindungsleitung 15 angeschlossen. Ein Kondensator 20 liegt mit seinem einen Anschluß an der Verbindungsleitung zwischen Widerstand 19 und Widerstand 18 und mit seinem anderen Anschluß an der Verbindungsleitung 21 zwischen dem positiven Ausgang der Spannungsquelle 11 und der Anode 8. An dieselbe Verbindungsleitung 21 ist ein Widerstand 22 angeschlossen, der mit dem zweiten Eingang des Differenzverstärkers 17 in Verbindung steht. Der Ausgang des Differenzverstärkers 17 führt über einen Widerstand 23 auf einen Eingang eines weiteren Differenzverstärkers 24, dessen weiterer Eingang über einen Widerstand 25 mit dem Abgriff 26 eines Potentiometers 27 in Verbindung steht. Dieser Potentiometer 27 liegt einerseits am negativen Anschluß einer Gleichspannungsquelle von z. B. 15 V und andererseits an der Leitung 21. Der Ausgang des Differenzverstärkers 17 ist über einen Widerstand 28 auf den negativen Eingang dieses Verstärkers 17 rückgekoppelt.

Die Drossel 10 dient dazu, den dynamischen Innenwiderstand der Gleichspannungsquelle 11 zu erhöhen, so daß der Kathodenstrom innerhalb eines vorgegebenen Zeitraums nur unwesentlich ansteigen kann.

Mit Hilfe des Schalters 9 ist es möglich, den Kathodenstrom zu unterbrechen, wenn eine tatsächliche oder sich anbahnende Bogenentladung detektiert wird. Der Schalter 9 kann auch Bestandteil der Spannungsquelle 11 sein oder sich zwischen der Spannunquelle 11 und der Drossel 10 befinden. Außerdem könnte er statt einer Abtrennung der Spannungsquelle 11 von der Kathode auch einen Kurzschluß zwischen Anode 8 und Kathode 6 bewirken.

Die beiden Widerstände 13, 14 stellen einen Spannungsteiler dar, während der Widerstand 19 zusammen mit dem Kondensator 20 ein RC-Glied darstellt, welches die auf eine verarbeitbare Größe herabgesetzte Kathodenspannung integriert. Die Integrationszeitkonstante, die sich aus dem mathematischen Produkt aus dem Widerstandswert des Widerstands 19 und dem Kapazitätswert des Kondensators 20 ergibt, wird so gewählt, daß bei einem vorgegebenen unteren Grenzwert für die Stellheit des Spannungsabfalls und bei einer festgelegten Mindestzeitdauer des Spannungsabfalls der für die Auslösung des Schalters 9 eingestellte Signalpegel erwirkt wird.

Die am Kondensator 20 integrierte Spannung wird mittels der herkömmlichen Differenzverstärkerschaltung 16, 17, 18, 22, 28 mit dem aktuellen Spannungswert verglichen. Die Ausgangsspannung des Differenzverstärkers 17 wird mit einer herkömmlichen Triggerschaltung 23, 24, 25 bewertet. Bei Überschreiten des Triggerschaltpunktes wird der Schalter 9 ausgelöst.

Für die Funktion der erfindungsgemäßen Schaltungsanordnung ist es unerheblich, ob, wie dargestellt, die Anode 8 und der Substratträger 4 elektrisch voneinander isoliert oder elektrisch miteinander verbunden oder identisch sind. Es ist auch gleichgültig, ob Anode 8 und Substratträger 4 beide oder nur einer von beiden am Endpotential der Vakuumkammer 1 liegen.

Als unterer Grenzwert für die Steilheit des Abfalls der Kathodenspannung wird 2 V/µs angesetzt, als Mindestzeitdauer 5 µs.

Wie man aus der vorstehenden Beschreibung erkennt, wird durch die erfindungsgemäße Schaltungsanordnung nicht eine einfache du/dt-Auswertung vorgenommen, weil eine klassische Differenzierschaltung mit einer Einkopplung des Wechselstromanteils der Kathodenspannung über einen Kondensator nicht zum Erfolg führt. Vielmehr würde durch eine reine Differenzierschaltung das Abbild der Kathodenspannung so "aufgerauht", daß die natürlichen Schwankungen im Sputterprozeß infolge von Belegungen der Elektroden, Unregelmäßigkeiten im Gasfluß und Substratbewegungen eine Vielzahl von fehlerhaften Lichtbogenmeldungen hervorrufen würden. Mit der vorliegenden Erfindung wird dagegen der Mittelwert der Kathodenspannung mit dem Augenblickswert der Kathodenspannung verglichen und nur dann, wenn ein dynamischer Grenzwert überschritten wird, ein Lichtbogensignal abgegeben.

Anders ausgedrückt: Es wird über einen Zeitabschnitt von etwa 5 µs der Mittelwert der Kathodenspannung gebildet. Wenn dieser Mittelwert zum Beispiel um 10 V negativer als die augenblicklich anliegende Kathodenspannung ist, wird der Schalter 9 betätigt.

Das Kriterium für die Schalthandlung ist somit das Überschreiten eines Schwellwerts der Differenzspannung aus augenblicklicher Spannung minus Spannungsmittelwert, der über einen definierten Zeitraum kontinuierlich gebildet wird.

Da alle prozeßbedingten Änderungen und Schwankungen in größeren Zeiträumen ablaufen als die Mittelwertbildung, folgt der Mittelwert der Kathodenspannung diesen Schwankungen.

## Patentansprüche

1. Unterdrückungsschaltungsanordnung von Lichtbögen in einem Plasma, wobei an der Plasmastrecke eine Spannungsquelle liegt, **dadurch gekennzeichnet**, daß der Augenblickswert der Spannung der Plasmastrecke (7, 5 bzw. 6, 8) mit einem Spannungswert verglichen wird, der einer über eine vorgegebene Zeit ermittelten mittleren Plasmaspannung entspricht, und daß dann, wenn die Differenz zwischen dem Augenblickswert der Plasmaspannung und der mittleren Plasmaspannung einen vorgegebenen Wert übersteigt, die Plasmastrecke von der Spannunquelle (11) getrennt wird.

2. Unterdrückungsschaltungsanordnung von Lichtbögen in einem Plasma nach Anspruch 1, **dadurch gekennzeichnet,** daß zur Erzeugung der über einer vorgegebenen Zeit ermittelten mittleren Plasmaspannung ein Integrationsglied (19, 20) vorgesehen ist, dessen Zeitkonstante so gewählt ist, daß bei einem vorgegebenen unteren Grenzwert für die Steilheit des Spannungsabfalls und bei einer festgelegten Mindestzeitdauer des Spannungsabfalls der für die Auslösung des die Spannunquelle (1) abtrennenden Schalters (9) notwendige Signalpegel erreicht wird.

3. Unterdrückungsschaltungsanordnung von Lichtbögen in einem Plasma nach Anspruch 2, **dadurch gekennzeichnet**, daß die am Integrationsglied (19, 20) aufintegrierte Spannung einem Eingang eines Differenzverstärkers (17) zugeführt ist, an dessen anderem Eingang der aktuelle Spannungswert anliegt.

4. Unterdrückungsschaltungsanordnung von Lichtbögen in einem Plasma nach Anspruch 3, **dadurch gekennzeichnet**, daß das Ausgangssignal des Differenzverstärkers (17) auf einen Eingang eines weiteren und als Trigger wirkenden Differenzverstärkers (24) gegeben ist, dessen anderer Eingang mit einer vorgegebenen Referenzspannung beaufschlagt ist.

5. Unterdrückungsschaltungsanordnung von Lichtbögen in einem Plasma nach Anspruch 4, **dadurch gekennzeichnet,** daß der Ausgang des weiteren Differenzverstärkers (24) mit einem Schalter (9) verbunden ist, der zwischen der Spannungsquelle (11) und einer Elektrode (6) der Plasmastrecke (6, 5) liegt.

6. Unterdrückungsschaltungsanordnung von Lichtbögen in einem Plasma nach Anspruch 5, **dadurch gekennzeichnet**, daß zwischen die Spannungsquelle (11) und den Schalter (9) eine Drossel (10) geschaltet ist.

## Claims

1. A circuit arrangement for suppressing arcs in a plasma, where a voltage source is connected to the plasma stage, characterised in that the instantaneous value of the voltage of the plasma stage (7, 5 and 6, 8) is compared with a voltage value which corresponds to a mean plasma voltage determined over a given time, and that whenever the difference between the instantaneous value of the plasma voltage and the mean plasma voltage exceeds a given value, the plasma stage is cut off from the voltage source (11).

2. A circuit arrangement for suppressing arcs in a plasma as claimed in Claim 1, characterised in that for the generation of the mean plasma voltage determined over a given time an integrator (19, 20) is provided, the time constant of which is selected such that at a given lower limit value for the gradient of the voltage drop and with a defined minimum duration of the voltage drop, the signal level necessary for the tripping of the switch (9), which cuts off the voltage source (1), is attained.

3. A circuit arrangement for suppressing arcs in a plasma as claimed in Claim 2, characterised in that the voltage integrated in the integrator (19, 20) is fed to an input of a differential amplifier (17), to the other input of which the current voltage value is applied.

4. A circuit arrangement for suppressing arcs in a plasma as claimed in Claim 3, characterised in that the output signal of the differential amplifier (17) is fed to one input of a further differential amplifier (24) which acts as trigger and the other input of which is supplied with a given reference voltage.

5. A circuit arrangement for suppressing arcs in a plasma as claimed in Claim 4, characterised in that the output of the further differential amplifier (24) is connected to a switch (9) which is located between the voltage source (11) and an electrode (6) of the plasma stage (6, 5).

6. A circuit arrangement for suppressing arcs in a plasma as claimed in Claim 5, characterised in that a choke (10) is connected between the voltage source (11) and the switch (9).

## Revendications

1. Dispositif de circuit pour la prévention d'arcs dans un plasma, une source de tension étant appliquée à la trajectoire de plasma, caractérisé en ce que la valeur momentanée de la tension de la trajectoire de plasma (7, 5 respectivement 6, 8) est comparée à une valeur de tension qui correspond à une tension de plasma moyenne établie sur un temps prédéterminé et en ce qu'ensuite, quand la différence entre la valeur momentanée de la tension de plasma et la tension de plasma moyenne dépasse une valeur prédéterminée, la trajectoire de plasma est isolée de la source de tension (11).

2. Dispositif de circuit pour la prévention d'arcs dans un plasma selon la revendication 1, caractérisé en ce que pour la génération de la tension moyenne de plasma établie sur un temps prédéterminé, il est prévu un organe d'intégration (19, 20) dont la constante temporelle est définie de manière que le niveau réglé du signal pour le déclenchement de l'interrupteur (9) séparant la source de tension (11) est provoqué à une valeur limite inférieure prédéterminée pour la raideur de pente de la chute de tension et à une durée de temps minimale définie de la chute de tension.

3. Dispositif de circuit pour la prévention d'arcs dans un plasma selon la revendication 2, caractérisé en ce que la tension intégrée à l'organe d'intégration (19, 20) est amenée à l'entrée d'un amplificateur différenciateur (17) dont l'autre entrée présente la valeur de tension effective.

4. Dispositif de circuit pour la prévention d'arcs dans un plasma selon la revendication 3, caractérisé en ce que le signal de sortie de l'amplificateur différenciateur (17) est donné à une entrée d'un autre amplificateur différenciateur (24) faisant office de trigger dont l'autre entrée est alimentée par une tension de référence prédéterminée.

5. Dispositif de circuit pour la prévention d'arcs dans un plasma selon la revendication 4, caractérisé en ce que la sortie de l'autre amplificateur différenciateur (24) est reliée à un interrupteur (9) se trouvant entre la source de tension (11) et une électrode (6) de la trajectoire de plasma (6, 5).

6. Dispositif de circuit pour la prévention d'arcs dans un plasma selon la revendication 5, caractérisé en ce qu'une bobine de réactance (10) intervient entre la source de tension (11) et l'interrupteur (9).
